# EUROPÄISCHE PATENTSCHRIFT

(11) **EP 1 489 696 B1**
(45) Veröffentlichungstag und Bekanntmachung des Hinweises auf die Patenterteilung: **18.01.2012**
(21) Anmeldenummer: 04012943.9
(22) Anmeldetag: 01.06.2004
(51) Int. Cl.: H01R 12/59, H05K 3/36

(54) **Verfahren zur Kontaktierung von leitfähigen Fasern**
Method for contacting conductive fibers
Procédé pour contacter des fibres conductrices

(30) Priorität: 06.06.2003 DE 10325883
(43) Veröffentlichungstag der Anmeldung: 22.12.2004
(73) Patentinhaber: Future-Shape GmbH, 85635 Höhenkirchen-Siegertsbrunn (DE)
(72) Erfinder: Jung, Stefan, 81249 München (DE); Lauterbach, Christl, 85635 Höhenkirchen-Siegertsbrunn (DE)
(74) Vertreter: Müller-Boré & Partner Patentanwälte

(56) Entgegenhaltungen:
- DE-A- 10 161 527
- DE-B- 1 085 207
- GB-A- 1 029 772

## Beschreibung

Die Erfindung betrifft ein Verfahren zum elektrischen Verbinden eines elektrischen Leiters mit einem elektronischen Bauelement gemäß Anspruch 1 sowie eine Vorrichtung gemäß Anspruch 11.

In zunehmendem Maße wird der Wunsch nach Kleidung und Accessoires geäußert, die außer ihren traditionellen Funktionen, wie z.B. Wärme, Schutz und Statussymbol, auch zusätzliche Funktionen wie Gesundheitsführsorge, persönliche Sicherheit, Kommunikation, etc., erfüllen können. Viele denkbare Applikationen für intelligente Kleidung (smart clothes) können durch die Integration von elektronischen Bauelementen und Modulen in den Textilien realisiert werden. Elektrische Verbindungen zwischen in der Kleidung verteilten elektronischen Modulen können z.B. mit in textilen Geweben eingewobenen leitfähigen Drähten realisiert werden. In der Regel werden diese elektrisch leitfähigen Fasern mit einem isolierenden Überzug versehen, um Kurzschlüsse durch Berührung der leitfähigen Fasern oder durch Feuchtigkeit, der die Kleidung beim Tragen ausgesetzt ist, zu verhindern. Sollen solche leitfähigen Fasern mit elektronischen Modulen verbunden werden, muß an den Kontaktstellen die Isolierung entfernt werden und eine elektrische Kontaktierung realisiert werden.

Bisher wurde der isolierende Überzug an den zu kontaktierenden Stellen durch eine Laserbehandlung entfernt. Die Nachteile dabei sind, daß ein Lasern der Kontaktstellen teuer ist und ein Einspannen der Textilbahnen nur insoweit möglich ist, wie diese relativ schmal sind und möglichst in einem roll to roll Prozess laufen können. Großflächige Gewebe können nur mit extrem großen und aufwendigen Apparaturen gelasert werden. Ein weiteres Problem ist die Reproduzierbarkeit von guten Kontaktwiderständen. Es entstehen kalte Lötstellen, die zur Ausfällen führen können.

Die DE 10 85 207 B offenbart einen Träger für zu verdrahtende elektrische Bauelemente für Fernsprechanlagen. Hierbei besteht der Träger aus einem geflochtenen Netz aus isolierten Drähten. Zum elektrischen Verbinden eines Bauelements mit einem der Drähte wird der Draht an einer Stelle durchtrennt, die Enden werden abisoliert und eine Lötöse des Bauelements wird zwischen die durchtrennten Enden gesteckt und mit diesen verlötet.

Die GB 1 029 772 A offenbart ein Gewebe, das in beiden Webkoordinaten aus blanken Drähten und Isolierstofffäden derart gewebt ist, dass sich die blanken Drähte an ihren Kreuzungsstellen nur dort berühren, wo dies aus schaltungstechnischen Gründen erforderlich ist. An den anderen Kreuzungsstellen dagegen werden die blanken Drähte durch die eingewebten Isolierstoffe voneinander getrennt gehalten.

Es ist somit Aufgabe der Erfindung, ein einfaches und kostengünstiges Verfahren zum elektrischen Verbinden eines Leiters mit einem elektronischen Bauelement vorzuschlagen. Es ist ferner Aufgabe der Erfindung, eine entsprechende Vorrichtung anzugeben.

Die das Verfahren betreffende Aufgabe wird durch ein Verfahren zum elektrischen Verbinden eines elektrischen Leiters mit einem elektronischen Bauelement gemäß Anspruch 1 gelöst. Die die Vorrichtung betreffende Aufgabe wird durch eine Vorrichtung gemäß Anspruch 11 gelöst. Bevorzugte Ausführungsformen sind Gegenstand der abhängigen Ansprüche.

Erfindungsgemäß umfaßt ein Verfahren zum elektrischen Verbinden eines elektrischen Leiters mit einem elektronischen Bauelement die Schritte:
- Bereitstellen eines textilen Materials, in welchem zumindest ein flexibler, draht- und/oder fadenartiger elektrischer Leiter angeordnet ist;
- Durchtrennen des elektrischen Leiters an der zu verbindenden Stelle;
- Anordnen einer Kontaktierungseinrichtung des Bauelements an zumindest einer Flächenseite des textilen Materials an der zu verbindenden Stelle des Leiters derart, dass die zu verbindende Stelle des Leiters von der Kontaktierungseinrichtung bedeckt wird;
- elektrisches Verbinden des Leiters mit der Kontaktierungseinrichtung.

Bei dem elektronischen Bauelement kann es sich beispielsweise um eine integrierte Schaltung (Chip) oder um eine auf einem Isolator aufgebrachte Leiterbahn, welche mit einem externen elektronischen Bauelement verbunden ist, handeln.

Vorzugsweise ist das textile Material ein Gewebe. Unter einem Gewebe wird hierbei ein textiles Flächengebilde aus zwei sich insbesondere rechtwinklig kreuzenden Fadensystemen verstanden, welche - wie üblich - als Kette und Schuß bezeichnet werden. Die Kette liegt in Längsrichtung des Webprozesses während die Schußrichtung quer zur Webrichtung verläuft.

Der Leiter umfaßt vorzugsweise zumindest einen Schuß- und/oder Kettfaden des Gewebes.

Das Durchtrennen des elektrischen Leiters an der zu verbindenden Stelle kann im Sinne dieser Erfindung sowohl in einem Mittelbereich des textilen Materials bzw. des elektrischen Leiters als auch an einem Seiten- bzw. Endbereich des textilen Materials bzw. des elektrischen Leiters durchgeführt werden. Wird der elektrische Leiter in dem Mittelbereich durchtrennt, so werden vorzugsweise die beiden sich gegenüberliegenden Schnittenden des elektrischen Leiters elektrisch mit der Kontaktierungseinrichtung verbunden. In dem Fall, in welchem das Durchtrennen des Leiters in einem Endbereich stattfindet, wird nur das eine Schnittende des Leiters, d.h. das offene Ende des Leiters elektrisch mit der Kontaktierungseinrichtung verbunden.

Vorzugsweise umfaßt das Verfahren ferner einen Schritt des Aufbringens eines Kontaktierungsmittels auf die Kontaktierungseinrichtung und/oder die durchtrennte Stelle des Leiters.

Vorzugsweise kann der Schritt des Aufbringens eines Kontaktierungsmittels auf die Kontaktierungseinrichtung produktionstechnisch an einer anderen Stelle durchgeführt werden als das tatsächliche elektrische Verbinden. So können beispielsweise mit dem Kontaktierungsmittel versehene Kontaktierungseinrichtungen vorgefertigt werden. Solche Kontaktierungseinrichtungen können dann in dem Verfahren gemäß der vorliegenden Erfindung weiterverarbeitet werden.

In einer bevorzugten Ausführungsform ist das Kontaktierungsmittel ein Lotmittel, vorzugsweise Lötzinn. Weiter bevorzugt umfaßt der Schritt des elektrischen Verbindens einen Schritt des Erhitzens des Lotmittels zum elektrischen Verbinden mit dem Leiter.

Durch das Erhitzen des Lotmittels läuft das Lotmittel von der zu kontaktierenden Stelle in das textile Gewebe und bedeckt die Stirnfläche bzw. Stirnflächen des durchtrennten Leiters. Dadurch wird der elektrische Kontakt zwischen dem Leiter und der Kontaktierungseinrichtung hergestellt.

Alternativ kann das Kontaktierungsmittel ein Leitkleber, vorzugsweise silbergefülltes Epoxidharz, sein.

Bei dem elektrischen Verbindungsschritt fließt hierbei der Leitkleber ähnlich wie das erhitzte Lotmittel in das textile Gewebe und bedeckt die Stirnfläche bzw. Stirnflächen des durchtrennten Leiters und stellt so eine elektrische Verbindung zwischen dem elektrischen Leiter und der Kontaktierungseinrichtung her.

In einer weiteren Alternative kann der Schritt des elektrischen Verbindens einen Schritt des Verschweißens des Leiters mit der Kontaktierungseinrichtung umfassen.

Vorzugsweise umfaßt das Verfahren ferner einen Schritt des elektrischen Verbindens der Kontaktierungseinrichtung mit dem elektronischen Bauelement.

Der Schritt des elektrischen Verbindens der Kontaktierungseinrichtung mit dem elektronischen Bauelement wird vorzugsweise nach dem Schritt des elektrischen Verbindens des Leiters mit der Kontaktierungseinrichtung durchgeführt. Alternativ kann dieser Schritt jedoch auch vor dem Anordnen der Kontaktierungseinrichtung an zumindest einer Flächenseite des textilen Materials an der zu verbindenden Stelle des Leiters durchgeführt werden.

Weiter bevorzugt kann die Kontaktierungseinrichtung als Teil des elektronischen Bauelements ausgebildet sein.

In einer bevorzugten Ausführungsform wird jeweils eine Kontaktierungseinrichtung an beiden Flächenseiten des textilen Materials angeordnet.

Dadurch kann erreicht werden, daß das Kontaktierungsmittel von beiden Flächenseiten des textilen Gewebes an der zu verbindenden Stelle in das textile Gewebe und den durchtrennten Leiter, insbesondere die Stirnseiten eindringen kann und somit eine bessere elektrische Verbindung ausgebildet wird. Gleichzeitig kann auch die mechanische Verbindung verbessert werden.

Vorzugsweise umfaßt der Leiter zumindest einen elektrisch leitenden Draht, welcher mit einer Isolierung ummantelt ist, und der Schritt des Durchtrennens des elektrischen Leiters umfaßt vorzugsweise ein Durchtrennen der Isolierung und des Drahts.

Überraschender Weise wurde festgestellt, daß es für das elektrische Verbinden des Leiters mit der Kontaktierungseinrichtung ausreicht, den elektrisch leitenden Draht des Leiters nur durch einen einfachen Schnitt durch den Leiter freizulegen. Durch das elektrische Verbinden der Strinfläche bzw. Strinflächen des durchtrennten elektrisch leitenden Drahts mit der Kontaktierungseinrichtung kann eine ausreichende Verbindung hergestellt werden.

Der elektrisch leitende Draht ist vorzugsweise aus einem Material mit geringem elektrischen Widerstand, z.B. Metall wie Cu, Ag, Au, Stahl, etc. oder ein elektrisch leitfähiger Kunststoff, wie z.B. ein Polymer, oder Carbonfasern ausgebildet. Die Isolierung bzw. der isolierende Überzug ist vorzugsweise aus einem Kunststoff, wie z.B. Polyester, Polyamid / -Imid, Polyurethan, etc.. Die Isolierung ist insbesondere vorgesehen, um Kurzschlüsse durch Berührung der leitenden Drähte bzw. Fasern oder durch Feuchtigkeit, der die Kleidung beim Tragen ausgesetzt ist, wie z.B. Regen, Schweiß, etc., zu verhindern. Der Schritt des Durchtrennens ist vorzugsweise ein mechanischer Schnitt, wie z.B. mit einer Schere oder einem Messer oder einem anderen Schneidwerkzeug, wobei der elektrische Leiter vorzugsweise gänzlich durchtrennt wird.

Gemäß der Erfindung wird ferner eine Vorrichtung bereitgestellt mit
- einem textilen Material, in welchem zumindest ein flexibler, draht- und/oder fadenartiger elektrischer Leiter angeordnet ist;
- zumindest einer Kontaktierungseinrichtung eines elektronischen Bauelements, welche mit dem Leiter elektrisch verbunden ist;
wobei
- der Leiter an der Verbindungsstelle mit der Kontaktierungseinrichtung durchtrennt ist, und
- die Kontaktierungseinrichtung an zumindest einer Flächenseite des textilen Materials an der Verbindungsstelle derart angeordnet ist, dass der durchtrennte Leiter von der Kontaktierungseinrichtung bedeckt wird.
.

Vorzugsweise sind die Kontaktierungseinrichtung und der Leiter mittels eines Kontaktierungsmittels elektrisch verbunden.

Bevorzugt ist das Kontaktierungsmittel ein Lotmittel.

Alternativ kann das Kontaktierungsmittel ein Leitkleber sein.

In einer bevorzugten Ausführungsform sind die Kontaktierungseinrichtung und der Leiter miteinander verschweißt.

Bevorzugt ist das Kontaktierungsmittel ein Lotmittel.

Alternativ kann das Kontaktierungsmittel ein Leitkleber sein.

In einer bevorzugten Ausführungsform sind die Kontaktierungseinrichtung und der Leiter miteinander verschweißt.

Bevorzugt ist die Kontaktierungseinrichtung als Teil des Bauelements ausgebildet.

Vorzugsweise ist die Kontaktierungseinrichtung ein Metallplättchen.

Das Metallplättchen kann beispielsweise aus Silber oder Kupfer bestehen. Typische Flächenabmessungen eines derartigen Metallplättchens entsprechen vorzugsweise der typischen Anzahl der parallel verlaufenden leitfähigen Garne bzw. Fasern bzw. Drähte, die einen Leiter ausbilden multipliziert mit dem typischen Garndurchmesser zuzüglich einer Justierzugabe aufgrund von Justierungenauigkeiten.

Bevorzugt ist das elektronische Bauelement ein Flexband.

Vorzugsweise ist das textile Material ein Gewebe und der Leiter umfaßt zumindest einen Schuß- und/oder Kettfaden des Gewebes.

Bevorzugt umfaßt der Leiter zumindest einen elektrisch leitenden Draht, welcher mit einer Isolierung ummantelt ist.

Ein Leiter kann somit vorzugsweise aus mehreren einzelnen leitenden Drähten bzw. Fasern ausgebildet sein, welche jeweils mit einer Isolierung ummantelt sind und in dem textilen Material eingearbeitet sind.

Weitere Aufgaben, Merkmale und Vorteile der vorliegenden Erfindung werden offensichtlich aus der nachfolgenden Beschreibung bevorzugter Ausführungsformen der vorliegenden Erfindungen mit Bezug auf die Zeichnungen, in welchen zeigt:
- Figuren 1A, 1B, 1C: schematische Ansichten in Aufsicht und Schnitt einer ersten Ausführungsform der Erfindung, bei welcher ein in einem textilen Material angeordneter Leiter durchtrennt wurde;
- Figuren 2A, 2B, 2C: schematischer Ansichten in Aufsicht und Schnitt der in Figuren 1A, 1B und 1C gezeigten Ausführungsform, bei welcher mit einem Kontaktierungsmittel versehene Kontaktierungseinrichtungen an der zu verbindenden Stelle des Leiters angeordnet wurden;
- Figuren 3A, 3B, 3C: schematische Ansichten in Aufsicht und Schnitt der Ausführungsform von Figuren 1A, 1B und 1C, im elektrisch verbundenen Zustand; und
- Figuren 4A, 4B, 4C: schematische Ansichten in Aufsicht und Schnitt einer zweiten Ausführungsform der Erfindung im elektrisch verbundenen Zustand.

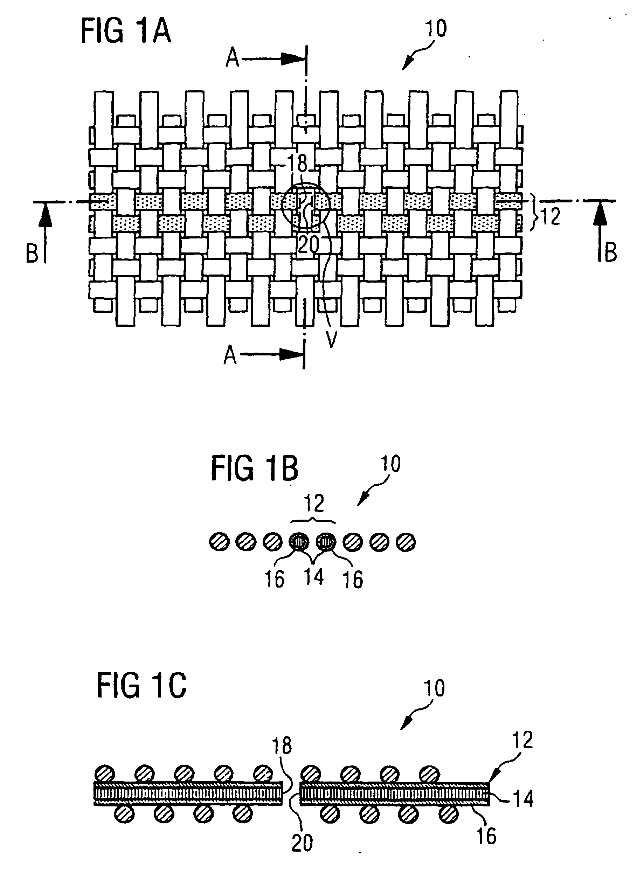

In Figuren 1A, 1B und 1C ist eine erste Ausführungsform einer erfindungsgemäßen Vorrichtung schematisch dargestellt.

Mit Bezugszeichen 10 ist ein textiles Material bezeichnet, bei welchem es sich um eine Gewebe handelt. Unter Gewebe wird hierbei ein textiles Flächengebilde aus zwei sich insbesondere rechtwinklig kreuzenden Fadensystemen verstanden, welche - wie üblich - als Kette und Schuß bezeichnet werden.

In dem textilen Material 10 ist ein elektrischer Leiter 12 eingewebt. In der dargestellten Ausführungsform, besteht der Leiter 12 aus zwei im wesentlichen parallel zueinander verlaufenden elektrisch leitenden Drähten bzw. Garnen bzw. Fasern 14, welche von einer elektrisch isolierenden Ummantelung bzw. Isolierung 16 umgeben sind. Der Leiter 12 kann jedoch je nach Anwendung auch jede andere beliebige Anzahl an Drähten aufweisen.

Fig. 1A zeigt eine Draufsicht auf die Vorrichtung gemäß der ersten Ausführungsform vor dem elektrischen Verbinden mit einem nicht dargestellten elektronischen Bauelement, Fig. 1B zeigt einen Schnitt entlang der Linie A-A von Fig. 1A und Fig. 1C zeigt einen Schnitt entlang der Linie B-B von Fig. 1A.

Um den Leiter 12 mit einem nicht dargestellten elektronischen Bauelement elektrisch zu verbinden, wird zunächst der Leiter 12 an der zu verbindenden Stelle V durchtrennt. Dies ist in Figuren 1A, 1B und 1C dargestellt. Das Durchtrennen des Leiters 12 erfolgt vorzugsweise durch einen mechanischen Schnitt mit einem herkömmlichen Schneidwerkzeug, wie z.B. einem Messer oder einer Schere. Hierbei wird vorzugsweise der Draht 14 und die Isolierung 16 vollständig durchtrennt und es entstehen zwei sich gegenüberliegende Schnittenden 18, 20 des Leiters 12. In der dargestellten Ausführungsform wurde der Leiter 12 in einen Mittelbereich durchtrennt.

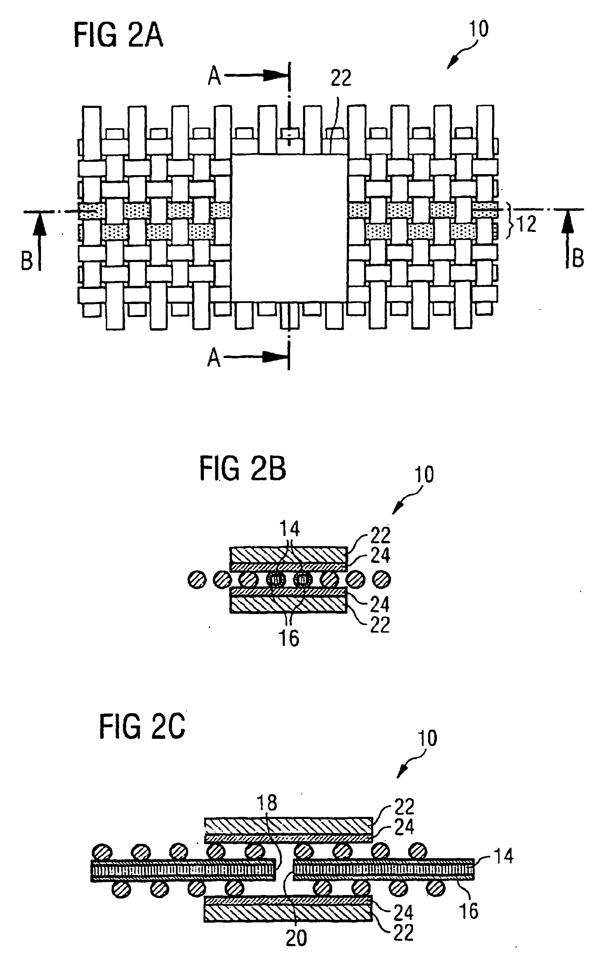

Nachfolgend wird das Anordnen einer Kontaktierungseinrichtung des Bauelements an dem textilen Material an der zu verbindenden Stelle des Leiters 12 mit Bezug auf Figuren 2A, 2B und 2C beschrieben.

Hierbei zeigt Fig. 2A eine Aufsicht auf eine Vorrichtung gemäß der ersten Ausführungsform im Anordnungsschritt, Fig. 2B einen Schnitt entlang Linie A-A von Fig. 2A und Fig. 2C einen Schnitt entlang Linie B-B von Fig. 2A.

Eine Kontaktierungseinrichtung 22 wird jeweils an beiden Flächenseiten des textilen Materials 10 derart positioniert, daß die zu verbindende Stelle V von der Kontaktierungseinrichtung 22 bedeckt wird. Die zwei verwendeten Kontaktierungseinrichtungen 22 sind vorzugsweise im wesentlichen gleich oder spiegelbildlich zueinander. Vorzugsweise werden die Kontaktierungseinrichtungen 22 derart angeordnet, daß sie sich im wesentlichen gegenüberliegen und das textile Material 10 mit dem Leiter 12 dazwischen liegt.

Die Kontaktierungseinrichtung 22 ist vorzugsweise als ein Metallplättchen ausgebildet, welches mit einem nicht dargestellten elektronischen Bauelement elektrisch verbunden werden kann. In der dargestellten Ausführungsform wird die Kontaktierungseinrichtung 22 erst nach dem elektrischen Verbinden des Leiters 12 mit der Kontaktierungseinrichtung 22 mit einem elektronischen Bauelement verbunden. Alternativ kann vorgesehen sein, daß das elektronische Bauelement bereits vor dem elektrischen Verbinden des Leiters 12 mit der Kontaktierungseinrichtung 22 mit der Kontaktierungseinrichtung 22 verbunden wird oder daß die Kontaktierungseinrichtung 22 einen Teil des elektronischen Bauelements ausbildet.

In der dargestellten Ausführungsform, ist die Kontaktierungseinrichtung 22 mit einem Kontaktierungsmittel 24 versehen. Bevorzugt ist das Kontaktierungsmittel 24 ein Lotmittel, am meisten bevorzugt Lötzinn. Alternativ kann das Kontaktierungsmittel 24 auch beispielsweise ein Leitkleber sein.

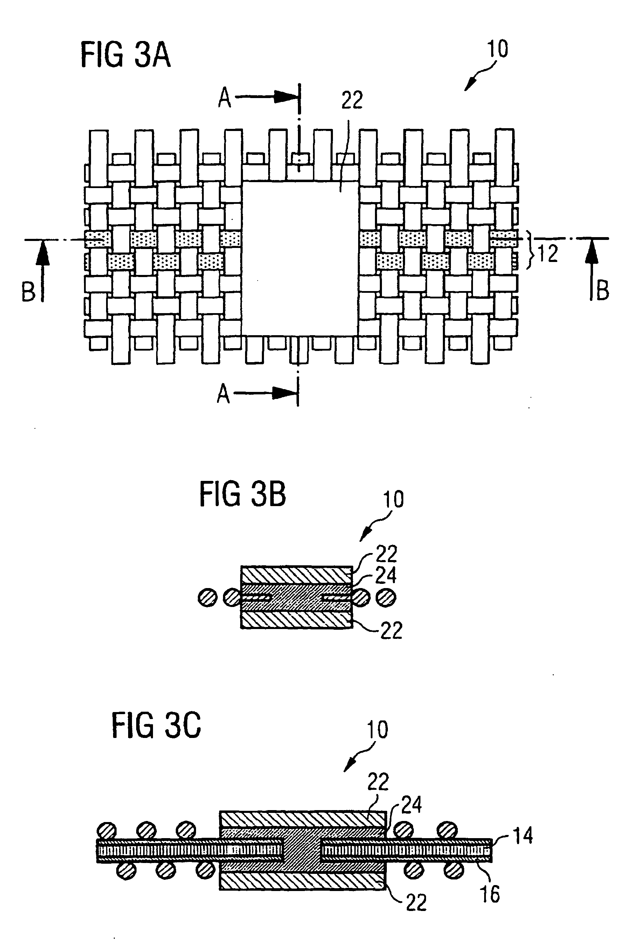

Fig. 3A, 3B und 3C zeigen eine erste Ausführungsform der erfindungsgemäßen Vorrichtung in einem elektrisch verbundenen Zustand. Hierbei zeigt Fig. 3A eine Aufsicht, Fig. 3B einen Schnitt entlang der Linie A-A von Fig. 3A und Fig. 3C einen Schnitt entlang Linie B-B von Fig. 3A.

Der in Figuren 2A, 2B und 2C dargestellten Kontaktierungseinrichtung 22 wurde Wärme bzw. Hitze zugeführt, so daß das Lotmittel 24 in das textile Material 10 geflossen ist. Hierbei werden auch die Schnittenden 18, 20 des durchtrennten Leiters 12 mit dem Lotmittel 24 kontaktiert. Insbesondere werden hierbei die Stirnflächen des durchtrennten Leiters 12 mit dem Lotmittel 24 versehen. Dadurch entsteht eine elektrische Verbindung zwischen dem Leiter 12 und der Kontaktierungseinrichtung 22.

Durch das Vorsehen von Kontaktierungseinrichtungen 22 an beiden Flächenseiten des textilen Materials 10 kann eine feste und sichere elektrische und mechanische Verbindung der Kontaktierungseinrichtung 22 mit dem textilen Material 10 und dem Leiter 12 ausgebildet werden.

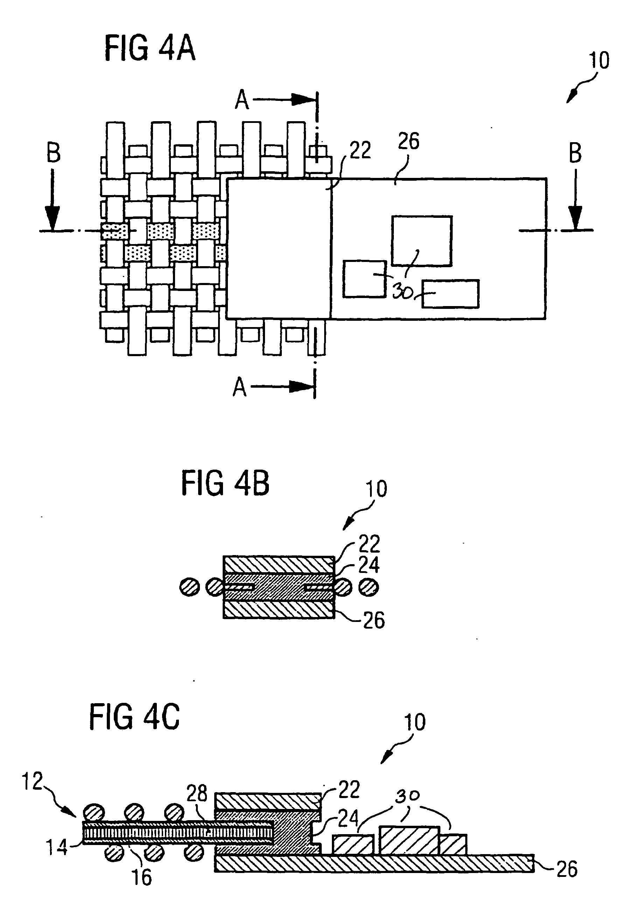

Figuren 4A, 4B und 4C zeigen eine Vorrichtung gemäß einer zweiten bevorzugten Ausführungsform der vorliegenden Erfindung. Hierbei zeigt Fig. 4A eine Aufsicht, Fig. 4B einen Schnitt entlang Linie A - A und Fig. 4C einen Schnitt entlang Linie B - B von Fig. 4A.

In der in Figuren 4A, 4B und 4C dargestellten Ausführungsform, wurde der Leiter 12 an einem Seiten- bzw. Rand- bzw. Kantenbereich des textilen Materials mit der Kontaktierungseinrichtung 22 elektrisch verbunden. Hierbei wurde der Leiter 12 an dem Seitenbereich durchtrennt.

In der dargestellten Ausführungsform ist an einer Flächenseite der textilen Material 10 eine wie bezüglich der ersten Ausführungsform beschriebene Kontaktierungseinrichtung 22 vorgesehen (obere Seite in Fig. 4C). An der anderen Flächenseite des textilen Materials 10 (untere Seite in Fig. 4C) ist die Kontaktierungseinrichtung als ein vorzugsweise integraler Bestandteil einer vorzugsweise flexiblen Leiterplatte 26 ausgebildet. An zumindest einer Seite der Leiterplatte 26 sind elektronische Bauelemente 30 vorgesehen.

Der Vorgang des elektrischen Verbindens erfolgt ähnlich wie in der ersten Ausführungsform, wobei jedoch in dieser Ausführungsform der zu verbindende Leiter 12 durchtrennt und nur ein Schnittende 28 des Leiters 12, in diesem Fall das seitliche Schnittende, elektrisch mit der Kontaktierungseinrichtung verbunden wird.

### Bezugszeichenliste

- 10: textiles Material
- 12: Leiter
- 14: Draht
- 16: Isolierung
- 18: Schnittende
- 20: Schnittende
- 22: Kontaktierungseinrichtung
- 24: Kontaktierungsmittel
- 26: flexible Leiterplatte
- 28: Schnittende
- 30: elektronisches Bauelement

## Patentansprüche

1. Verfahren zum elektrischen Verbinden eines elektrischen Leiters mit einem elektronischen Bauelement mit den Schritten:
- Bereitstellen eines textilen Materials (10), in welchem zumindest ein flexibler, draht- und/oder fadenartiger elektrischer Leiter (12) angeordnet ist;
- Durchtrennen des elektrischen Leiters (12) an der zu verbindenden Stelle (V);
- Anordnen einer Kontaktierungseinrichtung (22) des Bauelements an zumindest einer Flächenseite des textilen Materials (10) an der zu verbindenden Stelle (V) des Leiters (12) derart, dass die zu verbindende Stelle (V) des Leiters (12) von der Kontaktierungseinrichtung (22) bedeckt wird;
- elektrisches Verbinden des Leiters (12) mit der Kontaktierungseinrichtung (22).

2. Verfahren gemäß Anspruch 1, welches ferner einen Schritt des Aufbringens eines Kontaktierungsmittels (24) auf die Kontaktierungseinrichtung (22) und/oder die durchtrennte Stelle des Leiters (12) umfaßt.

3. Verfahren gemäß Anspruch 2, wobei das Kontaktierungsmittel (24) ein Lotmittel (24) ist.

4. Verfahren gemäß Anspruch 3, wobei der Schritt des elektrischen Verbindens einen Schritt des Erhitzens des Lotmittels (24) zum elektrischen Verbinden mit dem Leiter (12) umfaßt.

5. Verfahren gemäß Anspruch 2, wobei das Kontaktierungsmittel (24) ein Leitkleber ist.

6. Verfahren gemäß Anspruch 1, wobei der Schritt des elektrischen Verbindens einen Schritt des Verschweißens des Leiters (12) mit der Kontaktierungseinrichtung (22) umfaßt.

7. Verfahren gemäß einem der vorangehenden Ansprüche, welches ferner einen Schritt des elektrischen Verbindens der Kontaktierungseinrichtung (22) mit dem elektronischen Bauelement umfaßt.

8. Verfahren gemäß einem der vorangehenden Ansprüche, wobei die Kontaktierungseinrichtung (22) als Teil des elektronischen Bauelements ausgebildet ist.

9. Verfahren gemäß einem der vorangehenden Ansprüche, wobei jeweils eine Kontaktierungseinrichtung (22) an beiden Flächenseiten des textilen Materials (10) angeordnet wird.

10. Verfahren gemäß einem der vorangehenden Ansprüche, wobei der Leiter (12) zumindest einen elektrisch leitenden Draht (14), welcher mit einer Isolierung (16) ummantelt ist, umfaßt und der Schritt des Durchtrennens des elektrischen Leiters (12) ein Durchtrennen der Isolierung (16) und des Drahts (14) umfaßt.

11. Vorrichtung mit
- einem textilen Material (10), in welchem zumindest ein flexibler, draht- und/oder fadenartiger elektrischer Leiter (12) angeordnet ist;
- zumindest einer Kontaktierungseinrichtung (22) eines elektronischen Bauelements, welche mit dem Leiter (12) elektrisch verbunden ist;
wobei
- der Leiter (12) an der Verbindungsstelle mit der Kontaktierungseinrichtung (22) durchtrennt ist, und
- die Kontaktierungseinrichtung (22) an zumindest einer Flächenseite des textilen Materials (10) an der Verbindungsstelle derart angeordnet ist, dass der durchtrennte Leiter (12) von der Kontaktierungseinrichtung (22) bedeckt wird.

12. Vorrichtung gemäß Anspruch 11, wobei die Kontaktierungseinrichtung (22) und der Leiter (12) mittels eines Kontaktierungsmittels (24) elektrisch verbunden sind.

13. Vorrichtung gemäß Anspruch 12, wobei das Kontaktierungsmittel (24) ein Lotmittel (24) ist.

14. Vorrichtung gemäß Anspruch 13, wobei das Kontaktierungsmittel (24) ein Leitkleber ist.

15. Vorrichtung gemäß Anspruch 11, wobei die Kontaktierungseinrichtung (22) und der Leiter (12) miteinander verschweißt sind.

16. Vorrichtung gemäß einem der Ansprüche 11 bis 15, wobei die Kontaktierungseinrichtung (22) als Teil des Bauelements ausgebildet ist.

17. Vorrichtung gemäß einem der Ansprüche 11 bis 16, wobei die Kontaktierungseinrichtung (22) ein Metallplättchen ist.

18. Vorrichtung gemäß einem der Ansprüche 11 bis 17, wobei das elektronische Bauelement ein Flexband ist.

19. Vorrichtung gemäß einem der Ansprüche 11 bis 18, wobei das textile Material (10) ein Gewebe ist und der Leiter (12) zumindest einen Schuß- und/oder Kettfaden des Gewebes umfaßt.

20. Vorrichtung gemäß einem der Ansprüche 11 bis 19, wobei der Leiter (12) zumindest einen elektrisch leitenden Draht (14), welcher mit einer Isolierung (16) ummantelt ist, umfaßt.

## Claims

1. A method for electrically connecting an electrical conductor to an electronic component comprising the steps:
- a textile material (10) is provided in which at least one flexible wire-like and/or fiber-like electrical conductor (12) is arranged;
- the electrical conductor (12) is disconnected at the site to be connected (V);
- a contacting device (22) of the component is arranged on at least one surface side of the textile material (10) at the site (V) of the conductor (12) to be connected such that the site (V) of the conductor (12) to be connected is covered by the contacting device (22);
- the conductor (12) is electrically connected with the contacting device (22).

2. The method according to claim 1 which further comprises a step of applying a contacting means (24) on the contacting device (22) and/or the disconnected site of the conductor (12).

3. The method according to claim 2, wherein the contacting means (24) is a solder (24).

4. The method according to claim 3, wherein the electrical connection step is a step of heating the solder (24) to electrically connect with the conductor (12).

5. The method according to claim 2, wherein the contacting means (24) is a conductive adhesive.

6. The method according to claim 1, wherein the electrical connection step is a step of welding the conductor (12) to the contacting device (22).

7. The method according to one of the preceding claims that further comprises a step of electrically connecting the contacting device (22) to the electronic component.

8. The method according to one of the preceding claims, wherein the contacting device (22) is designed as a part of the electronic component.

9. The method according to one of the preceding claims, wherein a contacting device (22) is located on each of the two surface sides of the textile material (10).

10. The method according to one of the preceding claims, wherein the conductor (12) comprises at least one electrically conductive wire (14) that is sheathed with insulation (16), and the step of disconnecting the electrical conductor (12) comprises a disconnection of the insulation (16) and the wire (14).

11. A device comprising:
- a textile material (10) in which at least one flexible wire-like and/or thread-like electrical conductor (12) is arranged; '
- at least one contacting device (22) of an electronic component that is electrically connected to the conductor (12);
wherein
- the conductor (12) is disconnected at the connecting site with the contacting device (22), and
- the contacting device (22) is arranged on at least one surface side of textile material (10) at the connecting site such that the disconnected conductor (12) is covered by the contacting device (22).

12. The device according to claim 11, wherein the contacting device (22) and the conductor (12) are electrically connected by contacting means (24).

13. The device according to claim 12, wherein the contacting means (24) is a solder (24).

14. The device according to claim 13, wherein the contacting means (24) is a conductive adhesive.

15. The device according to claim 11, wherein the contacting device (22) and the conductor (12) are welded to each other.

16. The device according to one of claims 11 to 15, wherein the contacting device (22) is designed as a part of the component.

17. The device according to one of claims 11 to 16, wherein the contacting device (22) is a metal chip.

18. The device according to one of claims 11 to 17, wherein the electronic component is a flexible strip.

19. The device according to on of claims 11 to 18, wherein the textile material (10) is a fabric, and the conductor (12) comprises at least one warp and/or woof thread of the fabric.

20. The device according to one of claims 11 to 19, wherein the conductor (12) comprises at least one electrically conductive wire (14) that is sheathed with insulation (16).

## Revendications

1. Procédé pour connecter électriquement un conducteur électrique à un composant électronique comprenant les étapes suivantes :
- fourniture d'un matériau textile (10) dans lequel est disposé au moins un conducteur électrique (12) flexible de type fil métallique et/ou filament ;
- sectionnement du conducteur électrique (12) au niveau du point de connexion (V) ;
- positionnement d'un dispositif de mise en contact électrique (22) du composant sur au moins une face plane du matériau textile (10) au niveau du point de connexion (V) du conducteur (12), de telle sorte que le point de connexion (V) du conducteur (12) est recouvert par le dispositif de mise en contact électrique ;
- connexion électrique du conducteur (12) au dispositif de mise en contact électrique (22).

2. Procédé selon la revendication 1, comprenant en outre une étape d'application d'un moyen de mise en contact électrique (24) sur le dispositif de mise en contact électrique (22) et/ou sur le point sectionné du conducteur (12).

3. Procédé selon la revendication 2, le moyen de mise en contact électrique (24) étant un moyen de brasage (24).

4. Procédé selon la revendication 3, l'étape de connexion électrique comportant une étape de réchauffement du moyen de brasage (24) en vue de la connexion électrique avec le conducteur (12).

5. Procédé selon la revendication 2, le moyen de mise en contact électrique (24) étant une colle conductrice.

6. Procédé selon la revendication 1, l'étape de connexion électrique comprenant une étape de soudage du conducteur (12) au dispositif de mise en contact électrique (22).

7. Procédé selon une des revendications précédentes, comprenant en outre une étape de connexion électrique du dispositif de mise en contact électrique (22) au composant électronique.

8. Procédé selon une des revendications précédentes, le dispositif de mise en contact électrique (22) étant conçu comme une partie du composant électronique.

9. Procédé selon une des revendications précédentes, un dispositif de mise en contact électrique (22) étant disposé respectivement sur les deux faces planes du matériau textile (10).

10. Procédé selon une des revendications précédentes, le conducteur (12) comprenant au moins un fil métallique électriquement conducteur (14) qui est enrobé d'une isolation (16), et l'étape de sectionnement du conducteur électrique (12) comprend un sectionnement de l'isolation (16) et du fil (14).

11. Dispositif comportant
- un matériau textile (10) dans lequel est disposé au moins un conducteur électrique (12) flexible de type fil métallique et/ou filament ;
- au moins un dispositif de mise en contact électrique (22) d'un composant électronique qui est connecté électriquement au conducteur (12) ;
- le conducteur (12) est sectionné au niveau du point de connexion avec le dispositif de mise en contact électrique (22), et
- le dispositif de mise en connexion électrique (22) est disposé sur au moins une face plane du matériau textile (10) au niveau du point de connexion, de telle sorte que le conducteur sectionné (12) est recouvert par le dispositif de mise en contact électrique (22).

12. Dispositif selon la revendication 11, le dispositif de mise en contact électrique (22) et le conducteur (12) étant connectés électriquement à l'aide d'un moyen de mise en contact électrique (24).

13. Dispositif selon la revendication 12, le moyen de mise en contact électrique (24) étant un moyen de brasage (24).

14. Dispositif selon la revendication 13, le moyen de mise en contact électrique (24) étant une colle conductrice.

15. Dispositif selon la revendication 11, le dispositif de mise en contact électrique (22) et le conducteur (12) étant soudés l'un à l'autre.

16. Dispositif selon une des revendications 11 à 15, le dispositif de mise en contact électrique (22) étant conçu comme une partie du composant.

17. Dispositif selon une des revendications 11 à 16, le dispositif de mise en contact électrique (22) étant une plaquette métallique.

18. Dispositif selon une des revendications 11 à 17, le composant électronique étant une bande flexible.

19. Dispositif selon une des revendications 11 à 18, le matériau textile (10) étant un tissu et le conducteur (12) comprenant au moins un fil de trame et/ou un fil de chaîne du tissu.

20. Dispositif selon une des revendications 11 à 19, le conducteur (12) comprenant au moins un fil électriquement conducteur (14) qui est enrobé d'une isolation (16).
